Europäisches Patentamt

European Patent Office

Office européen des brevets

(11) Numéro de publication : **0 369 835 B1**

## (12) FASCICULE DE BREVET EUROPEEN

(45) Date de publication du fascicule du brevet :
**09.09.92 Bulletin 92/37**

(51) Int. Cl.$^5$ : **H03H 9/145, H03H 9/02**

(21) Numéro de dépôt : **89402784.6**

(22) Date de dépôt : **10.10.89**

(54) **Transducteur interdigité pour filtre à ondes de surface.**

(30) Priorité : **14.10.88 FR 8813536**

(43) Date de publication de la demande :
**23.05.90 Bulletin 90/21**

(45) Mention de la délivrance du brevet :
**09.09.92 Bulletin 92/37**

(84) Etats contractants désignés :
**DE FR GB**

(56) Documents cités :
**US-A- 4 365 220**

(56) Documents cités :
**IEEE TRANSACTIONS ON SONICS AND
ULTRASONICS, vol. SU-26, no. 4, juillet 1979,
pages 308-312, IEEE, New York, US; F. SAN-
DY:"Combining series sections weighting
with withdrawal weighting in surface acoustic
wave transducers"**

(73) Titulaire : **THOMSON-CSF
51, Esplanade du Général de Gaulle
F-92800 Puteaux (FR)**

(72) Inventeur : **Dufilie, Pierre
THOMSON-CSF SCPI Cédex 67
F-92045 Paris la Défense (FR)**

(74) Mandataire : **Desperrier, Jean-Louis et al
THOMSON-CSF SCPI
F-92045 PARIS LA DEFENSE CEDEX 67 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un transducteur à électrodes métalliques interdigitées en forme de peigne et déposées sur un substrat piézoélectrique. Le transducteur est inclus particulièrement dans un filtre à ondes de surface.

Dans un tel filtre, on cherche à réduire au maximum les pertes par insertion qui sont assez importantes. Les transducteurs interdigités doivent être désadaptés très fortement afin de réduire l'influence d'échos parasites de l'onde accoustique se propageant dans le filtre où les pertes excèdent généralement 20 dB.

Pour réduire les pertes d'insertion, il est connu de réaliser des filtres à transducteurs imbriqués à admittances conjuguées. Ce type de filtre est décrit dans l'article de M. HIKITA et al., "HIGH PERFORMANCE SAW FILTERS WITH SEVERAL NEW TECHNOLOGIES FOR CELLULAR RADIO", IEEE Trans. Microwave Theory Tech., vol. 33, N° 6, pages 510 à 517, 1985.

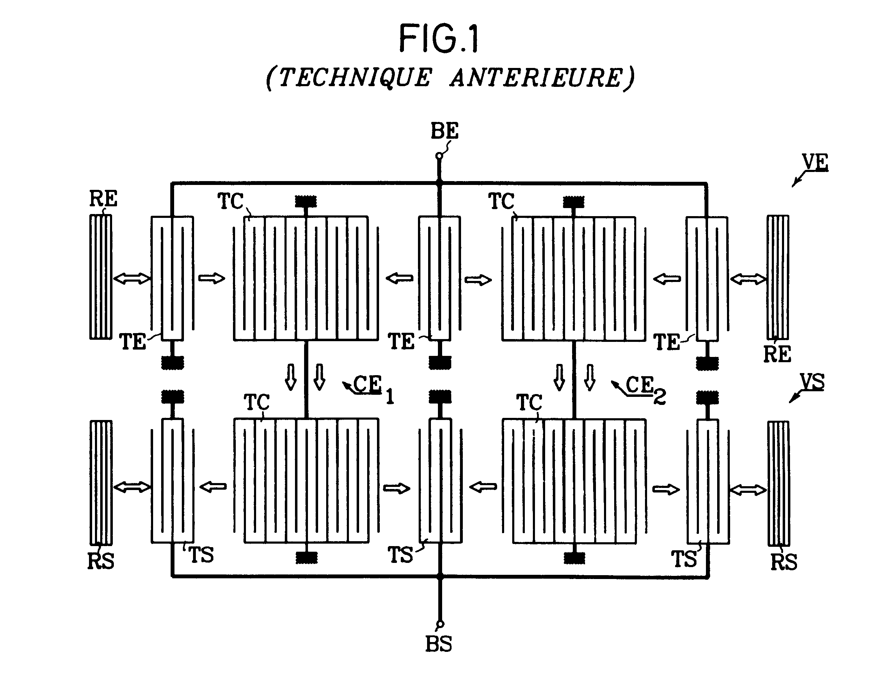

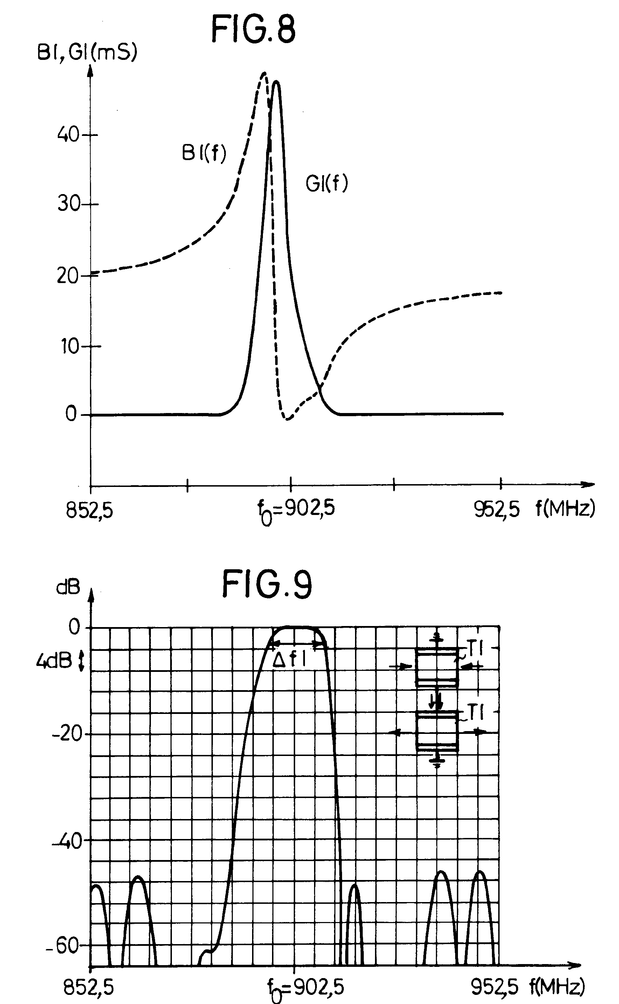

En se reportant à la Fig. 1 annexée, analogue à la Fig. 8a de l'article précité, ce type de filtre comporte, sur une surface principale du substrat, deux voies acoustiques parallèles d'entrée et de sortie VE et VS ayant en commun plusieurs cellules de couplage juxtaposées, par exemple deux cellules $CE_1$ et $CE_2$ selon la réalisation illustrée. Chaque cellule $CE_1$, $CE_2$ comprend deux transducteurs interdigités d'entrée TE reliés à une borne d'entrée BE du filtre, deux transducteurs interdigités de sortie TS reliés à une borne de sortie BS du filtre, et deux transducteurs interdigités intermédiaires, dits transducteurs de couplage TC (en Anglais "image-impedance connected IDT"), respectivement dans les voies VE et VS. Les deux transducteurs de couplage TC sont disposés respectivement entre les deux transducteurs d'entrée TE et les deux transducteurs de sortie TS et sont reliés en série. Deux cellules consécutives du filtre comprennent en commun un transducteur d'entrée et un transducteur de sortie. Le filtre comprend également des lignes à réseaux réfléchissants RE et RS aux extrémités de chacune des voies VE et VS.

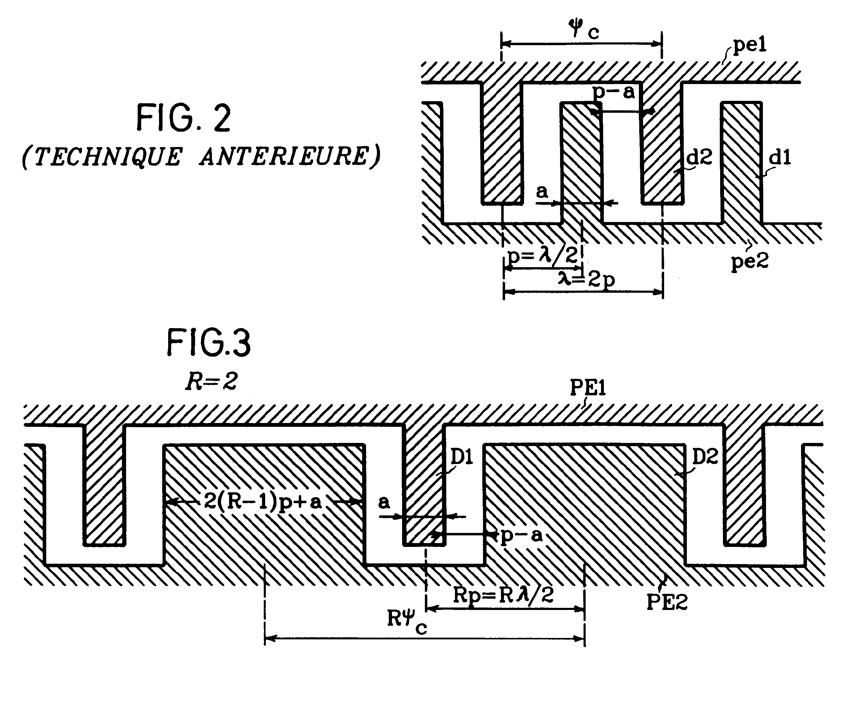

Les transducteurs de couplage TC contribuent à réduire les pertes dues à la bidirectionnalité. Comme montré à la Fig. 2 annexée, chaque transducteur de couplage comporte deux peignes métallisés périodiques en regard pe1 et pe2 ayant des électrodes en forme de doigts parallèles et alternés d1 et d2. Le pas de métallisation p entre deux doigts adjacents d1 et d2 est égal à la demi-longueur d'onde acoustique $\lambda/2$, ce qui correspond à une périodicité de doigt égale à $\lambda$ dans chacun des peignes pe1 et pe2, comme cela est connu dans les transducteurs à électrodes interdigitées. La largeur a de chacun des doigts d1 et d2 est constante et égale ou inférieure à $\lambda/4$.

Dans ces conditions, les électrodes du transducteur de couplage sont équivalentes à des sources acoustiques dont les vibrations s'ajoutent en phase pour des fréquences correspondant à des longueurs d'onde voisines du double du pas de métallisation p. La bande de fréquence d'arrêt du transducteur est alors donnée par :

$$2\pi - 2\Delta \leqq \Psi_c \leqq 2\pi + 2\Delta \text{ radians}$$

où $\Psi_c$ est l'angle électrique correspondant à la longueur physique 2p entre deux doigts adjacents dans un peigne, et $|\Gamma| = \sin\Delta$ désigne le coefficient de réflexion d'un doigt.

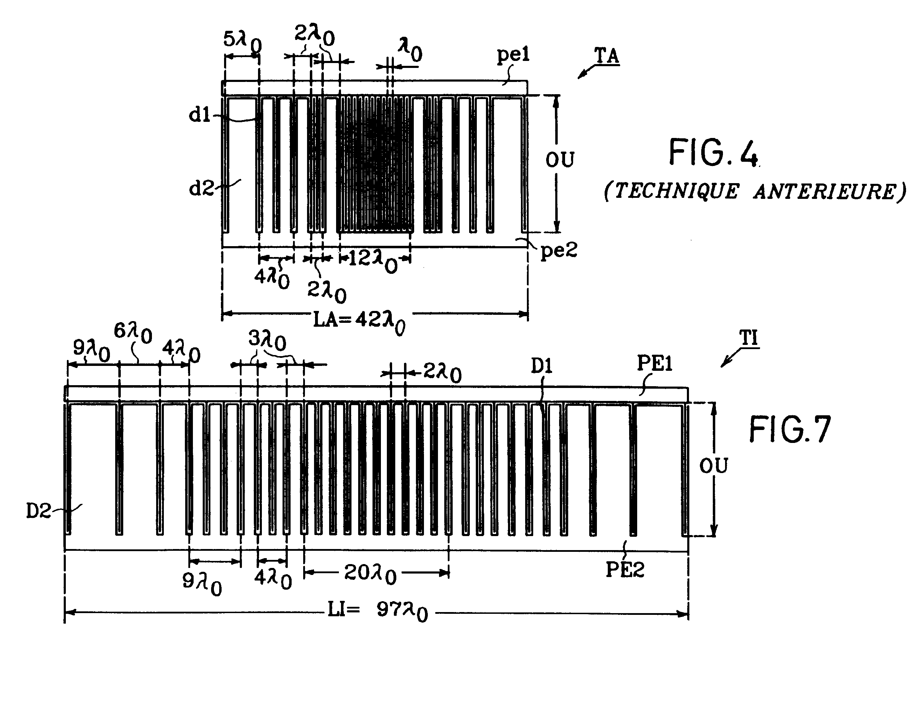

Pour assurer à un tel filtre un comportement satisfaisant dans sa bande passante, l'article précité (Fig. 4) recommande que le nombre de doigts actifs dans chacun des transducteurs de couplage soit sensiblement égal à $1,5/k^2$, où $k^2$ désigne le coefficient de couplage électromagnétique du substrat. Lorsque cette condition est réalisée, la susceptance de rayonnement B(f) du transducteur reste proche de zéro dans une bande de fréquence dont la largeur relative est de l'ordre de $k^2$. Cette bande offre des flancs très raides et pratiquement pas d'ondulation.

Toutefois, le niveau des lobes secondaires reste élevé, de l'ordre de 20 dB, et il est nécessaire de pondérer les transducteurs de couplage pour abaisser le niveau de ces lobes.

Selon l'art antérieur, deux techniques sont recommandées pour effectuer cette pondération. Selon une première technique, dite "apodization", et illustrée à la Fig. 3a de l'article précité, la longueur des doigts des peignes diminue progressivement de pont et d'autre du doigt actif central du transducteur. Selon une seconde technique, dite "en escalier", et illustrée à la Fig. 3b de l'article précité, les doigts actifs de largeur uniforme ont des configurations en marche d'escalier qui sont symétriques deux à deux de part et d'autre du doigt actif central rectiligne du transducteur.

Par ailleurs, une troisième technique de pondération peut être envisagée selon l'article de Clinton S. HARTMANN, intitulé "WEIGHTING INTERDIGITAL SURFACE WAVE TRANSDUCERS BY SELECTIVE WITHDRAWAL OF ELECTRODES", Ultrasonics Symposium Proceedings IEEE, 1973, p. 423 à 426. Cette technique consiste à retirer sélectivement des doigts dans le premier peigne et/ou le second peigne du transducteur.

La présente invention vise à réduire la largeur de la bande de fréquence d'un transducteur interdigité destiné notamment à servir de transducteur de couplage dans un filtre à ondes de surface à faibles pertes d'insertion.

A cette fin, un transducteur interdigité symétrique propre à propager une onde acoustique ayant une longueur d'onde centrale prédéterminée $\lambda_0$, et comprenant des premiers doigts d'un premier peigne et des seconds doigts d'un second peigne disposés alternativement sur un substrat est principalement caractérisé ence que l'entraxe entre un premier doigt et un second doigt adjacent à ce premier doigt est au moins égal à $R\lambda_0/2$, où R est pour la plus grande partie des doigts un entier strictement supérieur à 1.

Ainsi, comparativement à la technique antérieure, l'invention préconise une augmentation de la longueur optimale de chaque transducteur de couplage en réduisant le nombre de doigts actifs par unité de longueur. En fonction du facteur de réduction choisi, la bande de fréquence des transducteurs sera d'autant moins large.

D'autres caractéristiques de l'invention apparaîtront plus clairement à la lecture de la description suivante en référence aux dessins annexés correspondants dans lesquels :

    – la Fig. 1 est une vue schématique de dessus d'un filtre à ondes de surface à transducteurs de couplage selon la technique antérieure, déjà commenté ci-avant ;

    – la Fig. 2 montre une portion de la structure d'un transducteur de couplage connu, déjà commenté ci-avant ;

    – la Fig. 3 montre une portion, de préférence centrale, de la structure d'un transducteur selon l'invention ;

    – la Fig. 4 est une vue de dessus d'un transducteur connu obtenu selon la technique de "retrait de doigts" ;

    – les Figs. 5 et 6 montrent respectivement des variations des conductance et susceptance de rayonnement et la réponse en fonction de la fréquence pour le transducteur connu montré à la Fig. 4 ;

    – la Fig. 7 est une vue de dessus d'un transducteur du type à "retrait de doigts" selon l'invention ; et

    – les Figs. 8 et 9 montrent respectivement des variations de conductance et susceptance de rayonnement et la réponse en fonction de la fréquence pour le transducteur selon l'invention, montré à la Fig. 7.

En référence à la Fig. 3, un groupe périodique de paires de doigts situé de préférence au centre d'un transducteur interdigital symétrique selon l'invention présente un pas de métallisation égal à Rp. Le pas est défini par l'entraxe entre un doigt D1 d'un premier peigne PE1, tel que le peigne actif du transducteur, et un doigt D2 d'un second peigne PE2, tel que le peigne de masse du transducteur. La longueur $p=\lambda/2$ est égale au pas dans le transducteur connu, montré à la Fig. 2. Le facteur R est un entier strictement supérieur à 1, et égal à 2 selon la réalisation illustrée à la Fig. 3.

Ainsi, comparativement à la structure connue de la Fig. 2, la structure selon la Fig. 3 en est déduite en supprimant périodiquement R-1 doigts du peigne actif. Au moins la structure centrale des peignes selon l'invention a donc une périodicité égale à 2Rp, et une longueur optimale R fois plus grande que celle selon la Fig. 2. En d'autres termes, le nombre de doigts par unité de longueur de la structure est réduite du facteur R.

Les premiers doigts D1 ont une largeur a inférieure à $\lambda/2$, de préférence de l'ordre de $\lambda/4$, et égale à celle à des doigts d1 et d2 dans les premier et second peignes selon la technique antérieure ; de même, l'espace interélectrode entre deux côtés en regard de premier et second doigts adjacents D1 et D2 demeure inchangé et est égal à (p-a). En conséquence la largeur d'un second doigt D2 est égale à :

$$2Rp-2(p-a)-2a/2 = 2(R-1)p + a$$

et est nettement plus grande que la largeur a des seconds doigts d2 selon la Fig. 2.

La bande de fréquence d'arrêt de cette structure "réduite" est approximativement donnée par :

$$2R\pi - 2\Delta \leqq N\Psi_c \leqq 2R\pi + 2\Delta \text{ radians.}$$

La largeur de bande d'arrêt se trouve ainsi réduite dans un rapport voisin de 1/R par rapport à une structure "non réduite" selon la Fig. 2.

S'agissant de l'abaissement du niveau des lobes secondaires de la fonction de transfert d'un transducteur selon l'invention, celui-ci est obtenu par l'une quelconque des techniques antérieures évoquées précédemment, à savoir par des longueurs des doigts dans chacun des peignes variables (apodization), ou par des conformations en "marches d'escalier" des doigts, ou par "retrait" de doigts.

A titre d'exemple, des résultats expérimentaux sont indiqués ci-après pour un transducteur TA selon la technique antérieure et un transducteur TI selon l'invention, tous deux du type à "retrait de doigts". Le substrat piézoélectrique de ces transducteurs est en niobate de lithium $LiNbO_3$, coupe Y.128°, ayant un coefficient de couplage électromagnétique $k^2=0,056$. La fréquence centrale du transducteur est égale à 902,5 MHz qui correspond à une longueur d'onde $\lambda_0=2,16\mu m$ et une ouverture acoustique OU égale à 150 $\mu m$.

Comme montré à la Fig. 4, le transducteur TA selon la technique antérieure comporte $1,5/k^2 \cong 27$ premiers doigts d1 actifs qui sont répartis en un groupe central ayant 13 doigts espacés régulièrement de $\lambda_0$, deux premiers groupes symétriques ayant chacun trois doigts espacés régulièrement de $\lambda_0$, deux seconds groupes symétriques ayant chacun trois doigts espacés régulièrement de $2\lambda_0$, et deux doigts symétriques extrémaux. Comme cela apparaît, dans la Fig. 4, un doigt actif a été retiré entre le groupe central et chaque premier groupe, un doigt actif a été retiré entre chaque premier groupe et le second groupe voisin, et quatre doigts actifs ont été retirés entre chaque second groupe et le doigt extrémal voisin. La longueur active du transducteur TA est ainsi égale à $LA=42\lambda_0$.

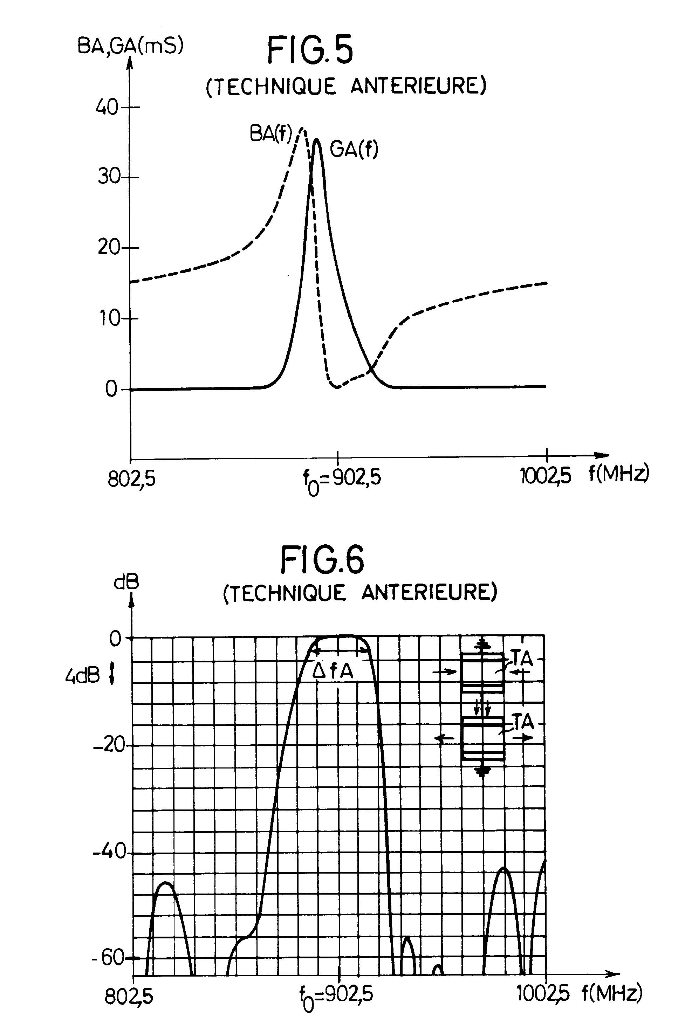

Pour le transducteur TA, les variations de la conductance GA et de la susceptance BA en fonction de la fréquence sont montrées à la Fig. 5. La réponse en fréquence de deux transducteurs TA couplés pour former une cellule élémentaire à deux transducteurs de couplage TC dans un filtre tel que montré à la Fig. 1 est montré à la Fig. 6. La largeur de bande à -3dB pour cette cellule est égale à $\Delta fA = 30,6$ MHz.

En référence à la Fig. 7, le transducteur TI selon l'invention constitue un transducteur de couplage TC également selon la technique de "retrait de doigts", c'est-à-dire dans lequel les entraxes entre des premiers et seconds doigts adjacents D1 et D2, et/ou entre des groupes de premiers et seconds doigts alternés augmentent progressivement et symétriquement à partir du centre du transducteur. Le transducteur TI comporte 31 doigts actifs qui sont répartis en un groupe central ayant 11 doigts espacés régulièrement de $R\lambda_0 = 2\lambda_0$, deux premiers groupes symétriques ayant chacun trois doigts espacés régulièrement de $2\lambda_0$, deux seconds groupes symétriques ayant chacun quatre doigts espacés régulièrement de $3\lambda_0$, et deux groupes symétriques extrémaux ayant trois doigts qui sont respectivement espacés de $4\lambda_0$, $6\lambda_0$ et $9\lambda_0$ à partir du second groupe voisin. L'espace entre le groupe central et chaque premier groupe est égal à $3\lambda_0$, et l'espace entre chaque premier groupe et le second groupe voisin est égal à $3\lambda_0$. La longueur active LI du transducteur TI est ainsi égale à $97\lambda_0$.

D'une manière analogue aux Figs. 5 et 6, mais pour une bande de fréquence réduite d'un facteur 2, les Figs. 8 et 9 indiquent respectivement les variations des conductance GI et susceptance BI du transducteur TI en fonction de la fréquence, et la réponse en fréquence de deux transducteurs TI formant une cellule de couplage TC+TC dans le filtre de la Fig. 1.

La largeur de bande $\Delta fl$ à -3dB d'atténuation pour la cellule à deux transducteurs TI est égale à 13,5 MHz. Cette largeur correspond donc à une réduction de $30,6/13,5 = 2,3$ par rapport à la largeur de bande de la paire de transducteurs TA, réduction qui est proche du rapport d'augmentation des longueurs des transducteurs, soit $LI/LA = 97/42 = 2,3$.

Les exemples décrits ci-dessus sont limités à un nombre relativement restreint de doigts, mais il est bien connu que les filtres à ondes de surface peuvent comporter couramment un nombre beaucoup plus grand de doigts, pouvant atteindre plusieurs centaines. Dans ces conditions, il est clair que la présence, pour diverses raisons, d'un petit nombre de doigts pour lesquels $R=1$ n'apportera qu'une très faible modification à la courbe de réponse et que le résultat de l'invention sera toujours obtenu. L'invention s'étend donc à de tels filtres.

**Revendications**

1 - Transducteur interdigité symétrique propre à propager une onde acoustique ayant une longueur d'onde centrale prédéterminée $\lambda_0$, et comprenant des premiers doigts (D1) d'un premier peigne (PE1) et des seconds doigts (D2) d'un second peigne (PE2) disposés alternativement sur un substrat, caractérisé en ce que l'entraxe entre un premier doigt (D1) et un second doigt (D2) adjacent à ce premier doigt est au moins égal à $R\lambda_0/2$, ou R est pour la plus grande partie des doigts un entier strictement supérieur à 1.

2 - Transducteur conforme à la revendication 1, caractérisé en ce que la largeur des seconds doigts (D2) est au moins égale à $(R-1)\lambda_0 + a$, où a désigne la largeur des premiers doigts (D1) inférieure à $\lambda_0/2$.

3 - Transducteur conforme à la revendication 1 ou 2, caractérisé en ce que la longueur des premiers et seconds doigts (D1, D2) diminue progressivement à partir d'un doigt central.

4 - Transducteur conforme à la revendication 1 ou 2, caractérisé en ce que les premiers et seconds doigts (D1, D2) de part et d'autre d'un doigt central ont des configurations en marches d'escalier.

5 - Transducteur conforme à la revendication 1 ou 2, caractérisé en ce que les entraxes entre des premiers et seconds doigts adjacents (D1, D2) et/ou les écarts entre des groupes de premiers et seconds doigts alternés augmentent progressivement et symétriquement à partir du centre du transducteur, chacun desdits entraxes ou écarts étant égal à $M\lambda_0/2$, où M est un entier égal ou supérieur à R.

6 - Filtre à ondes de surface, caractérisé en ce qu'il comprend au moins un transducteur conforme à l'une quelconque des revendications 1 à 5.

7 - Filtre à ondes de surface, caractérisé en ce qu'il comprend au moins une cellule à transducteurs d'entrée et de sortie (TE, TS) qui sont couplés par un ou deux transducteurs de couplage (TC), caractérisé en ce que le ou les transducteurs de couplage sont conformes à l'une quelconque des revendications 1 à 5.

**Patentansprüche**

1. Interdigitaler symmetrischer Transduktor für die Übertragung eine akustische Welle einer vorgegebenen mittleren Wellenlänge $\lambda_0$, mit ersten Fingern (D1) eines ersten Kamms (PE1) und zweiten Fingern (D2) eines zweiten Kamms (PE2), die abwechselnd auf einem Substrat angeordnet sind, dadurch gekennzeichnet, daß der Achsabstand zwischen einem ersten Finger (D1) und einem diesem benachbarten zweiten Finger (D2) mindestens gleich $R\lambda_0/2$ ist, wobei R für die Mehrzahl der Finger eine ganze Zahl ist, die in jedem Fall größer als 1 ist.

2. Transduktor nach Anspruch 1, dadurch gekennzeichnet, daß die Breite der zweiten Finger (D2) mindestens gleich $(R-1)\lambda_0+a$ ist, wobei a die Breite der ersten Finger (D1) bezeichnet, die kleiner als $\lambda_0/2$ ist.

3. Transduktor nach Anspruch 1 oder 2, dadurch gekennzeichnet, daß die Länge der ersten und zweiten Finger (D1, D2) stetig von einem mittleren Finger aus abnimmt.

4. Transduktor nach Anspruch 1 oder 2, dadurch gekennzeichnet, daß die ersten und zweiten Finger (D1, D2) zu beiden Seiten eines mittleren Fingers abgestufte Konfigurationen aufweisen.

5. Transduktor nach Anspruch 1 oder 2, dadurch gekennzeichnet, daß die Achsabstände zwischen benachbarten ersten und zweiten Fingern (D1, D2) und/oder die Abstände zwischen Gruppen von abwechselnden ersten und zweiten Fingern stetig und symmetrisch von der Transduktormitte aus zunehmen, wobei jeder der Achsabstände oder Gruppenabstände gleich $M\lambda_0/2$ ist, wobei M eine ganze Zahl gleich oder größer R ist.

6. Oberflächenwellenfilter, dadurch gekennzeichnet, daß es mindestens einen Transduktor gemäß einem der Ansprüche 1 bis 5 enthält.

7. Oberflächenwellenfilter, dadurch gekennzeichnet, daß es mindestens eine Zelle mit Eingangstransduktoren (TE) und Ausgangstransduktoren (TS) besitzt, die über einen oder zwei Kopplungstransduktoren (TC) gekoppelt sind, dadurch gekennzeichnet, daß der Kopplungstransduktor oder die Kopplungstransduktoren gemäß einem der Ansprüche 1 bis 5 ausgebildet sind.

**Claims**

1. Symmetric interdigital transducer capable of propagating an acoustic wave having a predetermined central wavelength, $\lambda_0$, and comprising first fingers (D1) of a first comb (PE1) and second fingers (D2) of a second comb (PE2) which are arranged alternately on a substrate, characterised in that the distance between the axes of a first finger (D1) and a second finger (D2) adjacent to this first finger is at least equal to $R\lambda_0/2$, where R is for the major part of the fingers an integer strictly greater than 1.

2. Transducer according to Claim 1, characterised in that the width of the second fingers (D2) is at least equal to $(R-1)\lambda_0+a$, where a denotes the width, less than $\lambda_0/2$, of the first fingers (D1).

3. Transducer according to Claim 1 or 2, characterised in that the length of the first and second fingers (D1, D2) decreases progressively from a central finger.

4. Transducer according to Claim 1 or 2, characterised in that the first and second fingers (D1, D2) on either side of a central finger have staircase configurations.

5. Transducer according to Claim 1 or 2, characterised in that the distances between the axes of first and second adjacent fingers (D1, D2) and/or the gaps between groups of first and second alternate fingers increase progressively and symmetrically from the centre of the transducer, each of the said distances between axes or gaps being equal to $M\lambda_0/2$, where M is an integer equal to or greater than R.

6. Surface wave filter, characterised in that it comprises at least one transducer according to any one of Claims 1 to 5.

7. Surface wave filter, characterised in that it comprises at least one cell with input and output transducers (TE, TS) which are coupled by one or two coupling transducers (TC), characterised in that the coupling transducer(s) conform(s) with any one of Claims 1 to 5.

# FIG.1

## (TECHNIQUE ANTERIEURE)

EP 0 369 835 B1

FIG. 2
(TECHNIQUE ANTERIEURE)

FIG.3
R=2

FIG. 4
(TECHNIQUE ANTERIEURE)

$5\lambda_0$  $2\lambda_0$  $\lambda_0$  pe1  TA

d1
d2

OU

pe2

$4\lambda_0$  $2\lambda_0$  $12\lambda_0$

LA = $42\lambda_0$

FIG. 7

$9\lambda_0$  $6\lambda_0$  $4\lambda_0$  $3\lambda_0$  $2\lambda_0$  D1  PE1  TI

D2

OU

$9\lambda_0$  $4\lambda_0$  $20\lambda_0$

PE2

LI = $97\lambda_0$

EP 0 369 835 B1

FIG.5
(TECHNIQUE ANTERIEURE)

FIG.6
(TECHNIQUE ANTERIEURE)

# FIG.8

# FIG.9